# EUROPEAN PATENT SPECIFICATION

(11) **EP 1 218 764 B1**
(45) Date of publication and mention of the grant of the patent: **22.08.2007**
(21) Application number: 00944522.2
(22) Date of filing: 13.06.2000
(51) Int. Cl.: G01R 29/00, G01R 29/08

(54) **PROCEDURE AND SYSTEM AT WIRELESS TELECOMMUNICATIONS SYSTEM**
VERFAHREN UND SYSTEM IN EINEM DRAHTLOSEN TELEKOMMUNIKATIONSSYSTEM
PROCEDURE ET SYSTEME DANS UN SYSTEME DE TELECOMMUNICATIONS HERTZIENNES

(30) Priority: 14.06.1999 SE 9902232
(43) Date of publication of application: 03.07.2002
(73) Proprietor: TELIA AB, 123 86 Farsta (SE)
(72) Inventor: OLSSON, Bo, S-136 53 Haninge (SE)
(74) Representative: Hopfgarten, Nils
(86) International application number: PCT/SE2000/001241
(87) International publication number: WO 2000/077532

(56) References cited:
- WO-A1-97/29557
- US-A- 4 661 820
- US-A- 4 884 078
- US-A- 5 365 241

## Description

### Field of the invention

The present invention relates to a method and a system for measuring the efficiency of a transmitter antenna in an environment with multipath propagation according to the preambles of claims 1 and 8 respectively.

### Technical background

Traditionally mobile telephony has been executed via fixed mounted antennas in vehicles or antennas located at a distance from a handset of the mobile telephone. In most cases there has been a complete, or at least partly, clear view between the mobile telephone antenna and the base station antenna. The efficiency, i.e. the relation between the transmitted power from the mobile telephone antenna and the received power in the base station antenna, of mobile telephone antennas can under these circumstance be measured by measuring the direct power that is transmitted from the antenna.

The development of handhold units for mobile telephony with an antenna mounted directly at the handset of the mobile telephone, however, has resulted in that clear view between the mobile telephone antenna and the base station antenna in most cases does not exist. Use in urban environment, indoors, outdoors or in cars, has resulted in that screening by buildings, car body and the user himself/herself has become an obvious factor for the efficiency of mobile telephone antennas. Mobile telephone antennas in these cases operate in an environment with multipath propagation. Mobile telephone antennas with low efficiency have high utilisation of battery capacity because there is required high output power to achieve sufficient received power in the base station. This results in that the standby time of the mobile telephone will be short. Poor efficiency also reduces the coverage of the mobile telephone network in which the mobile telephones are used, because the area that is covered by each base station antenna will be small. This results in lost profit for the network operator, alternatively increased costs for location of a larger number of base station antennas.

Methods and equipments for testing antennas are previously known from e.g. US 4 661 820, US 5 365 241 and WO 97 29557.

Thus in US 4 661 820 is described a method for picking up the radiation pattern of an antenna. The transmitter antenna and the receiver antenna are turned into different angles in relation to each other. The radiation pattern of the receiver antenna is calculated from the measurements.

US 5 365 241 discloses a method and an apparatus for performing antenna measurements. An antenna under test is rotatably supported by a platform and a field probe is moved along arcs of varying radia in front of the antenna under test while it is rotating. In this way the near-field of the antenna is measured.

In WO 97 29557 a method is described allowing evaluation of how antenna tiltings change the coverage area of a base station of a mobile telecommunications system. Measured data of field strength of mobile units of the system at different geographical places before and after the antenna tilting are compared to get a picture of how antenna tiltings changes the coverage area.

The today used measuring methods that are performed in real environment give rise to difficulties to obtain a standardised measure of the efficiency of the mobile telephone antennas of different manufacturers.

Another problem with the measuring methods of today is that certain parts of the fields are not registered at measuring because the measuring methods are designed for measuring of the direct field from the mobile telephone antenna. Screening of different kinds give rise to change of the characteristic of the field. The measuring therefore leads to results that do not provide a good measure of the real efficiency of the antennas.

### Summary of the invention

The aim o the present invention is to, to some extent, remedy above mentioned problems.

This aim is achieved, according to the invention, by a method and system of the kind described in the introduction having the characteristics according to claims 1 and 8 respectively. Preferred embodiments are defined in the dependent claims.

According to one aim of the invention, a method for measuring the efficiency of a transmitter antenna in an environment with multipath propagation is achieved. According to the method, a receiver antenna, which is arranged at an angle to a first vertical axis, is turned azimuthally about one turn round the first vertical axis; at a number of angle positions during the turning of the receiver antenna, received power, from one at a distance and at an angle to a second vertical axis arranged vertical transmitter antenna, is detected, and the transmitter antenna is turned about one turn around the second vertical axis.

Because both the mobile telephone antenna and the receiver antenna are turned, measuring values can be obtained for a large part of the conceivable relations between their location in relation to each other and to the user. Advantages of this are that a normalised measure of the efficiency of the mobile telephone antenna can be obtained, and that the method can be repeated for different mobile telephones, and their efficiency can be compared with each other. The way of arranging the receiver antenna and the mobile telephone antenna in relation to each other, makes it possible to detect such a large part of the real field from the mobile telephone antenna.

According to another aim of the invention, a system for measuring of the power of antenna in a diffuse field is achieved. The system includes a transmitter antenna, a receiver antenna for detection of received power from the transmitter antenna, a first turning device for azimuthal turning of the receiver antenna around a first vertical axis, and a second turning device for turning of the transmitter antenna around a second vertical axis.

An advantage of this system is that it can simulate the real using environment of the mobile telephone antenna at the same time as it makes possible repeated trials with different mobile telephone antennas under equivalent conditions. By the system making possible measuring for different conditions between the mobile telephone antenna and the receiver antenna, it also provides a measure of the average efficiency of the tested mobile telephone antenna. In addition, the way the receiver antenna and the mobile telephone antenna are arranged individually and in telephone antenna are in relation to each other, makes possible that such a large part of the real field of the mobile telephone antenna can be detected.

When measuring of the efficiency of a mobile telephone antenna that is used in an environment with multipath propagation, it is of great importance that this is made in such a realistic environment as possible, so that such a real measure as possible of the efficiency of the mobile telephone antenna is obtained.

According to the invention, a method and a system for measuring of the efficiency of an antenna in an environment with multipath propagation, which can be utilised for repeated trials in controlled laboratory environment that gives normalised measures of the efficiency of different mobile telephone antennas, are achieved. It is especially important to make it possible to compare the performance of different antennas in such a true and realistic way as possible. By use of a measurement on a reference antenna with known transmitted power, a reference value is obtained with which the different mobile telephone antennas can be compared. Such a measure then can be used for recommendation of certain mobile telephone antennas before others, so that the mobile telephone antennas that are most efficient are used. In this way the mobile telephone networks can be utilised more efficient and have larger coverage.

By using a receiver antenna that is arranged at an angle to a vertical axis, in contrast to receiver antennas which are either vertical or horizontal, both plan-polarised and horizontal-polarised fields are measured. This is important, because the normal environment in which the mobile telephone antenna is used gives rise to changes in the polarisation of the fields.

### Brief description of the drawings

The invention will described in details in the following, with reference to enclosed schematic drawings, which, with the aim of exemplifying, shows preferred embodiments of the invention.
Figure 1 shows a side view of a system for measuring of the efficiency of a transmitter antenna in an environment with multipath propagation according to a preferred embodiment of the invention.
Figure 2 shows a flat view of a part of the system in Figure 1.
Figure 3 shows a detailed side view of a mobile telephone arranged at a simulated head, which is a part of the system in Figure 2.
Figure 4 shows a flow chart of a preferred method for measuring of the efficiency of a transmitter antenna in an environment with multipath propagation.

### Description of preferred embodiments

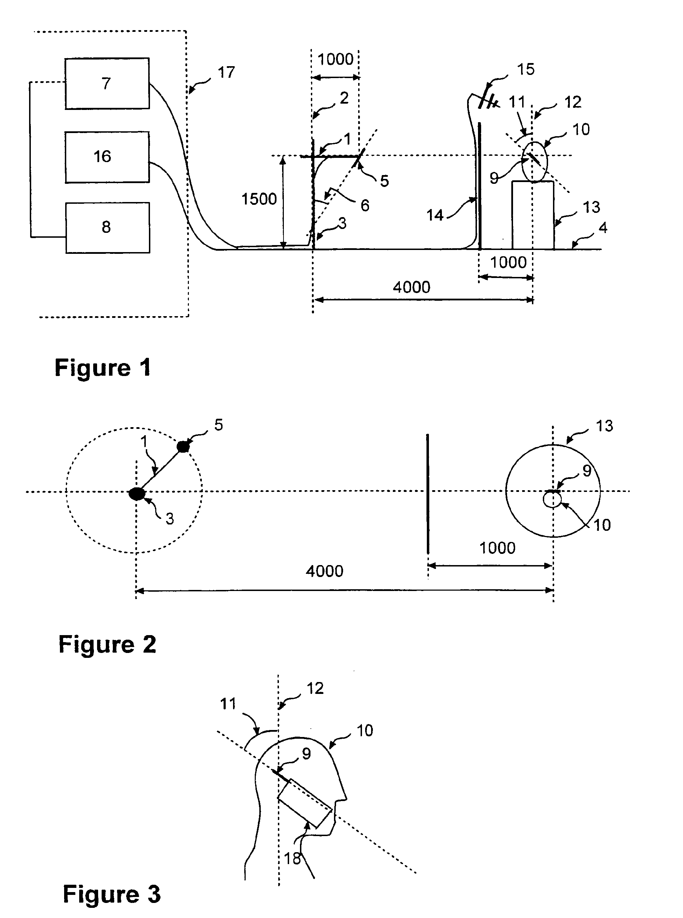

In Figure 1 is shown a system for measuring of the efficiency of a transmitter antenna in an environment with multipath propagation, according to a preferred embodiment of the invention.

A horizontal arm 1 is, at one of its ends, in a turnable way, round a first vertical axis 2, arranged on a stand 3 so that the distance between a horizontal laboratory floor 4 and the arm 1 is 1,5 m. In the, to the first vertical axis 2, opposite end of the horizontal arm 1, a receiver antenna 5 is arranged so that the distance between the first vertical axis 2, round which the horizontal arm 1 is turned, and the receiver antenna 5 is 1 m. The receiver antenna 5 is arranged at an angle 6 to the first vertical axis 2, at which the angle 6 preferably is 55°. The receiver antenna 5 is a dipole antenna 5, which is connected to a spectrum analyser 7, which in it turn is connected to a PC 8.

At a distance of 4 m in horizontal direction there is a transmitter antenna 9 in form of a mobile telephone antenna 9. The mobile telephone antenna 9 is mounted on a mobile telephone (not shown), which is mounted on a simulated head 10, in form of a model filled with 22,2 1 water with 1,49 g/l salt, at which the mobile telephone antenna 9 forms an angle 11 of 60° to a second vertical axis 12. The simulated head 10 is in its turn standing on a wooden stand 13, which is turnable round the second vertical axis 12. At the mobile telephone 12, there is a simulated hand (not shown) in form of a rubber glove, which contains the same solution as the simulated head 10. The mobile telephone antenna 9 is, as the receiver antenna 5, located at a distance of 1,5 m over the horizontal laboratory floor 4.

Between the receiver antenna 5 and the mobile telephone antenna 9 is a copper screen 14 for prevention of direct wave propagation between the mobile telephone antenna 9 and the receiver antenna 5. The screen 14 has a width of 1,2 m, and a height of 2,2 m and is located 1 m in horizontal direction from the mobile telephone antenna 9. On top of the screen 14 there is a base station antenna 15, which is connected to a mobile communication test equipment 16.

The mobile communication test equipment 16, the spectrum analyser 7, and the PC 8, shall be placed behind a screen so that they do not influence the standing-wave pattern.

In Figure 2 is shown a flat view of a part of the system in Figure 1. The mobile telephone antenna 9 is so placed that it is on the other vertical axis 12, round which the wooden stand 13 is turnable.

In Figure 3 the simulated head 12 in Figure 1 and 2 is shown in more details. The mobile telephone 18 is placed as it should be at use.

According to another preferred embodiment of a system according to the invention, a reference antenna is tested. The system is identical with the in Figure 1 shown system, with the exception that the mobile telephone antenna 9 has been replaced by a reference antenna, in form of a dipole antenna, and that the simulated head 11 and the simulated hand are lacking. The reference antenna is located at the wooden stand 13 and forms, as the mobile telephone antenna in Figure 2, an angle of 60° to the second vertical axis 12. The reference antenna is so located that it is 1,5 m above the horizontal laboratory floor 4 on the second vertical axis 12, round which the wooden stand 13 is turned.

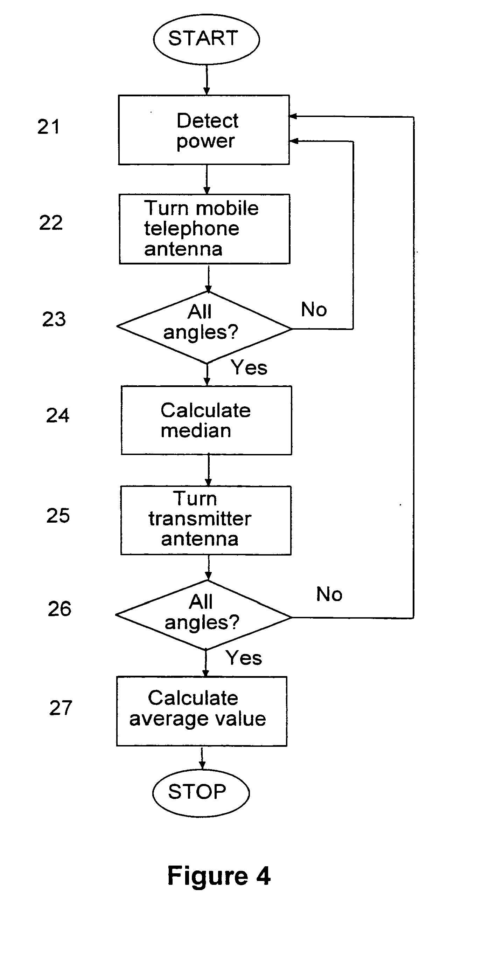

In Figure 4 is shown a flow chart of a preferred procedure for measuring of the efficiency of a transmitter antenna in an environment with multipath propagation.

The procedure starts with that the mobile telephone is set in conversation state. In a detection step 21, the power from the transmitter antenna that is received by the receiver antenna is detected, after which the arm with the receiver antenna arranged at it is turned 1/100 turn in a first turning step 22. In a first question step 23 is decided whether detection has been made for all wanted angle positions of the arm. If that is the case, an average value of the detected power is calculated in a first calculating step 24; if not, the procedure goes back to the detection step 21.

After the first calculation step 24, the wooden stand, at which the transmitter antenna is arranged, is turned, in a second turning step 25, one eight of a turn, after which it in a second question step 26 is decided whether detection has been made for all wanted angle positions of the wooden stand. If that is the case, an average value is calculated in a second calculation step 27 of the in the first calculation step 24 calculated average values; if not, the procedure will continue with the detection step 21.

After the second calculation step 24 the procedure is finished.

It is realised that a lot of modifications of the above described embodiments of the invention are possible within the frame of the invention, as defined by the following patent claims. For instance can distance and angles be changed to adapt to different simulated conditions. The simulated head and the hand can be exchanged for radiation influencing bodies of other forms. The measuring also can be performed by means of other, equivalent equipment.

## Claims

1. Method for measuring the efficiency of a transmitter antenna (9) in an environment with multipath propagation, including the steps:
to azimuthally turn a receiver antenna (5), which is arranged at an angle to a first vertical axis (2), about one turn around the first vertical axis (2),
to detect power received from said transmitter antenna (9) arranged at a distance and at an angle to a second vertical axis (12) at a number of angle positions during the turning of the receiver antenna, and
to turn the transmitter antenna (9) about one turn around the second vertical axis (12), **characterized in that** direct wave propagation between the transmitter antenna (9) and the receiver antenna (5) is prevented by means of a screen (14) arranged between the transmitter antenna (9) and the receiver antenna (5), and **in that** said receiver antenna (5) is arranged at an extended arm at an angle (6) of 40 - 60° to said first vertical axis and said transmitter antenna (9) is arranged at an angle of 60° to said second axis.

2. Method as claimed in claim 1, wherein the steps above are repeated at a number of different angle positions of the receiver antenna (5).

3. Method as claimed in claims 1 or 2, wherein the transmitter antenna (9) is a dipole antenna, which transmits known power.

4. Method as claimed in claims 1 or 2, wherein the transmitter antenna (9) is a mobile telephone antenna which shall be tested, the power transmitted by said mobile telephone antenna being unknown.

5. Method as claimed in claim 2, wherein average values of the results of measuring at different angle positions of the receiver antenna (5) are calculated.

6. Method as claimed in claim 5, wherein the calculation of average values includes the steps:
to calculate, for each angle position during the turning of the transmitter antenna (9), an average value of the detected power of the transmitter antenna for the different angle positions of the receiver antenna (5), and
to calculate an average value of the average values of the detected power of the transmitter antenna (9).

7. Method as claimed in claim 6, wherein the steps are included:
to make the steps above where the transmitter antenna (9) first is a mobile telephone antenna and then a reference antenna, and
to compare the average value of the mobile telephone antenna with the average value of the reference antenna.

8. System for measuring the efficiency of a transmitter antenna (9) in an environment with multipath propagation, including:
a transmitter antenna (9),
a receiver antenna (5) for detection of received power from the transmitter antenna,
a first turning device for azimuthal turning of the receiver antenna around a first vertical axis (2),
a second turning device for turning of the transmitter antenna (9) around a second vertical axis (12), **characterized in that** a screening device (14) is arranged between the transmitter antenna (9) and the receiver antenna (5) for prevention of direct wave propagation between the transmitter antenna and the receiver antenna, and **in that** said first turning device is an extended arm at which the receiver antenna (5) is arranged at an angle (6) of 40 - 60° to the first vertical axis (2) and the transmitter antenna (9) is arranged at an angle of 60° to the second vertical axis (12).

9. System as claimed in claim 8, wherein said extended arm (1) is turnable around said first vertical axis (2) at one end of the arm, in that the receiver antenna (5) is arranged at the opposite end of the arm (1), and in that the transmitter antenna (9) is arranged at a distance from the receiver antenna.

10. System as claimed in claim 9, wherein the transmitter antenna (9) is a mobile telephone antenna with unknown transmission, said mobile telephone antenna being arranged at a first radiation influencing body which is arranged at a distance from the receiver antenna (5) and is turnable around said second vertical axis (12).

11. System as claimed in claim 9, wherein the transmitter antenna (9) is a reference antenna which transmits known power.

12. System as claimed in any of the claims 9 - 11, wherein the receiver antenna (5) is arranged at the extended arm at an angle (6) of 55°.

13. System as claimed in any of the claims 9-12, wherein the receiver antenna (5) is a halfwave dipole.

14. System as claimed in any of the claims 9 - 13, wherein a spectrum analyser (7) is connected to the transmitter antenna (9), and a computer (8) is connected to the spectrum analyser.

15. System as claimed in any of the claims 9 -14, wherein a mobile communication test equipment (16) is connected to a base station antenna (15).

16. System as claimed in claim 10, wherein a second radiation influencing body is arranged at the mobile telephone antenna.

## Patentansprüche

1. . Verfahren zum Messen der Leistungsfähigkeit einer Senderantenne (9) in einer Umgebung mit Mehrfachweg-Ausbreitung, das die Schritte einschließt:
azimutal eine Empfängerantenne (5), die unter einem Winkel zu einer ersten vertikalen Achse (2) angeordnet ist, um eine Umdrehung um die erste vertikale Achse (2) zu drehen,
die Leistung, die von der Senderantenne (9), die in einer Entfernung und unter einem Winkel zu einer zweiten vertikalen Achse (12) angeordnet ist, bei einer Anzahl von Winkelstellungen während des Drehens der Empfängerantenne empfangen wird, zu ermitteln, und
die Senderantenne (9) um eine Umdrehung um die zweite vertikale Achse (12) zu drehen, **dadurch gekennzeichnet, dass** Direktwellenausbreitung zwischen der Senderantenne (9) und der Empfängerantenne (5) mit Hilfe einer Abschirmung (14) verhindert wird, die zwischen der Senderantenne (9) und der Empfängerantenne (5) angeordnet ist, und dass die Empfängerantenne (5) an einem verlängerten Arm unter einem Winkel (6) von 40 bis 60° zur ersten vertikalen Achse angeordnet ist und die Senderantenne (9) unter einem Winkel von 60° zur zweiten Achse angeordnet ist.

2. . Verfahren nach Anspruch 1, bei dem die obigen Schritte bei einer Anzahl von unterschiedlichen Winkelstellungen der Empfängerantenne (5) wiederholt werden.

3. . Verfahren nach Anspruch 1 oder 2, bei dem die Senderantenne (9) eine Dipolantenne ist, die bekannte Leistung sendet.

4. . Verfahren nach Anspruch 1 oder 2, bei dem die Senderantenne (9) eine Mobiltelefonantenne ist, die untersucht werden soll, wobei die Leistung, die durch die Mobiltelefonantenne gesendet wird, unbekannt ist.

5. . Verfahren nach Anspruch 2, bei dem Durchschnittswerte der Messergebnisse bei unterschiedlichen Minkelstellungen der Senderantenne (5) berechnet werden.

6. . Verfahren nach Anspruch 5, bei dem die Berechnung von Durchschnittswerten die Schritte aufweist:
für jede Winkelstellung während des Drehens der Senderantenne (9) einen Durchschnittswert der ermittelten Leistung der Senderantenne für die unterschiedlichen Winkelstellungen der Empfängerantenne (5) zu berechnen, und
den Durchschnittswert der Durchschnittswerte der ermittelten Leistung der Senderantenne (9) zu berechnen.

7. . Verfahren, nach Anspruch 6, bei dem die Schritte eingeschlossen sind:
die obigen Schritte zu unternehmen, wo die Senderantenne (9) erst eine Mobiltelefonantenne und dann eine Bezugsantenne ist, und
den Durchschnittswert der Mobiltelefonantenne mit dem Durchschnittswert der Bezugsantenne zu vergleichen.

8. . System zum Messen der Leistungsfähigkeit einer Senderantenne (9) in einer Umgebung mit Mehrfachweg-Ausbreitung, das einschließt:
eine Senderantenne (9),
eine Empfängerantenne (5) für Ermittlung von von der Senderantenne empfangener Leistung,
eine erste Dreheinrichtung für azimutale Drehung der Empfängerantenne um eine erste vertikale Achse (2), eine zweite Dreheinrichtung zum Drehen der Senderantenne (9) um eine zweite vertikale Achse (12), **dadurch gekennzeichnet, dass** eine Abschirmeinrichtung (14) zwischen der Senderantenne (9) und der Empfängerantenne (5) zur Verhinderung von Direktwellenausbreitung zwischen der Senderantenne und der Empfängerantenne angeordnet ist, und dass die erste Dreheinrichtung ein verlängerter Arm ist, an dem die Empfängerantenne (5) unter einem Winkel (6) von 40 bis 60° zur ersten vertikalen Achse (2) angeordnet ist, und die Senderantenne (9) unter einem Winkel von 60° zur zweiten vertikalen Achse (12) angeordnet ist.

9. . System nach Anspruch 8, bei dem der verlängerte Arm (1) an einem Ende des Armes um die erste vertikale Achse (2) drehbar ist, die Empfängerantenne (5) am gegenüberliegende Ende des Arms (1) angeordnet ist, und dass die Empfängerantenne (9) in eine Entfernung von der Empfängerantenne angeordnet ist.

10. . System nach Anspruch 9, bei dem die Senderantenne (9) eine Mobiltelefonantenne mit unbekannter Sendung ist, wobei die Mobiltelefonantenne an einem ersten Strahlung beeinflussenden Körper angeordnet ist, der in einer Entfernung von der Empfängerantenne (5) angeordnet ist und um die zweite vertikale Achse (12) drehbar ist.

11. . System nach Anspruch 9, bei dem die Senderantenne (9) eine Bezugsantenne ist, die bekannte Leistung sendet.

12. . System nach einem der Ansprüche 9 bis 11, bei dem die Empfängerantenne (5) am verlängerten Arm unter einem Winkel (6) von 55° angeordnet ist.

13. . System nach einem der Ansprüche 9 bis 12, bei dem die Empfängerantenne (5) ein Halbwellendipol ist.

14. . System nach einem der Ansprüche 9 bis 13, bei dem ein Spektrumanalysierer (7) mit der Senderantenne (9) verbunden ist und ein Computer (8) mit dem Spektrumanalysierer verbunden ist.

15. . System nach einem der Ansprüche 9 bis 14, bei dem eine mobile Kommunikationsprüfausrüstung (16) mit einer Basisstationsantenne (15) verbunden ist.

16. . System nach Anspruch 10, bei dem ein zweiter Strahlung beeinflussender Körper an der Mobiltelefonantenne angeordnet ist.

## Revendications

1. Procédé de mesure du rendement d'une antenne émettrice (9) dans un environnement avec propagation à chemins multiples, comprenant les étapes suivantes :
rotation en azimut d'une antenne réceptrice (5), qui est inclinée par rapport à un premier axe vertical (2), d'un tour environ autour du premier axe vertical (2) ;
détection de la puissance reçue en provenance de la dite antenne émettrice (9) placée à distance et inclinée par rapport à un deuxième axe vertical (12), à plusieurs positions angulaires pendant la rotation de l'antenne réceptrice ; et
rotation de l'antenne émettrice (9) d'un tour environ autour du deuxième axe vertical (12),
**caractérisé en ce qu'**une propagation d'onde directe entre l'antenne émettrice (9) et l'antenne réceptrice (5) est empêchée au moyen d'un écran (14) placé entre l'antenne émettrice (9) et l'antenne réceptrice (5), et **en ce que** la dite antenne réceptrice (5) est montée sur un bras allongé et suivant un angle (6) de 40 à 60 degrés par rapport au dit premier axe vertical et la dite antenne émettrice (9) est montée suivant un angle de 60 degrés par rapport au dit deuxième axe

2. Procédé selon la revendication 1, dans lequel les étapes ci-dessus sont répétées à une pluralité de positions angulaires différentes de l'antenne réceptrice (5).

3. Procédé selon les revendications 1 ou 2, dans lequel l'antenne émettrice (9) est une antenne dipôle, qui transmet une puissance connue.

4. Procédé selon les revendications 1 ou 2, dans lequel l'antenne émettrice (9) est une antenne de téléphone mobile qui doit être testée, la puissance émise par la dite antenne de téléphone mobile étant inconnue.

5. Procédé selon la revendication 2, dans lequel les valeurs moyennes des résultats de mesure à différentes positions angulaires de l'antenne réceptrice (5) sont calculées.

6. Procédé selon la revendication 5, dans lequel le calcul des valeurs moyennes comprend les étapes suivantes :
calcul, pour chaque position angulaire pendant la rotation de l'antenne émettrice (9), d'une valeur moyenne de la puissance détectée de l'antenne émettrice pour les différentes positions angulaires de l'antenne réceptrice (5), et
calcul d'une valeur moyenne des valeurs moyennes de la puissance détectée de l'antenne émettrice (9).

7. Procédé selon la revendication 6, comprenant les étapes suivantes :
exécution des étapes ci-dessus lorsque l'antenne émettrice (9) est d'abord une antenne de téléphone mobile et ensuite une antenne de référence, et
comparaison de la valeur moyenne de l'antenne de téléphone mobile avec la valeur moyenne de l'antenne de référence.

8. Système de mesure du rendement d'une antenne émettrice (9) dans un environnement avec propagation à chemins multiples, comprenant :
une antenne émettrice (9),
une antenne réceptrice (5) pour détection de la puissance reçue en provenance de l'antenne émettrice,
un premier dispositif de rotation pour la rotation en azimut de l'antenne réceptrice autour d'un premier axe vertical (2),
un deuxième dispositif de rotation pour la rotation de l'antenne émettrice (9) autour d'un deuxième axe vertical (12),
**caractérisé en ce qu'**un dispositif d'écran (14) est placé entre l'antenne émettrice (9) et l'antenne réceptrice (5) pour empêcher une propagation d'onde directe entre l'antenne émettrice et l'antenne réceptrice, et **en ce que** le dit premier dispositif de rotation est un bras allongé sur lequel l'antenne réceptrice (5) est montée suivant un angle (6) de 40 à 60 degrés par rapport au premier axe vertical (2) et l'antenne émettrice (9) est montée suivant un angle de 60 degrés par rapport au deuxième axe vertical (12).

9. Système selon la revendication 8, dans lequel le dit bras allongé (1) peut tourner autour du dit premier axe vertical (2) à une première extrémité du bras, en ce que l'antenne réceptrice (5) est montée à l'extrémité opposée du bras (1), et en ce que l'antenne émettrice (9) est placée à une certaine distance de l'antenne réceptrice.

10. Système suivant la revendication 9, dans lequel l'antenne émettrice (9) est une antenne de téléphone mobile de transmission inconnue, la dite antenne de téléphone mobile étant placée sur un premier corps influençant le rayonnement qui est placé à une certaine distance de l'antenne réceptrice (5) et qui peut tourner autour du dit deuxième axe vertical (12).

11. Système selon la revendication 9, dans lequel l'antenne émettrice (9) est une antenne de référence qui transmet une puissance connue.

12. Système selon une quelconque des revendications 9 à 11, dans lequel l'antenne réceptrice (5) est montée sur le bras allongé, suivant un angle (6) de 55 degrés.

13. Système selon une quelconque des revendications 9 à 12, dans lequel l'antenne réceptrice (5) est un dipôle demi-onde.

14. Système selon une quelconque des revendications 9 à 13, dans lequel un analyseur de spectre (7) est connecté à l'antenne émettrice (9), et un ordinateur (8) est connecté à l'analyseur de spectre.

15. Système selon une quelconque des revendications 9 à 14, dans lequel un équipement de test de communication mobile (16) est connecté à une antenne de station de base (15).

16. Système selon la revendication 10, dans lequel un deuxième corps influençant le rayonnement est placé à l'endroit de l'antenne de téléphone mobile.
